Europäisches Patentamt

European Patent Office

Office européen des brevets

(11) Veröffentlichungsnummer: **0 125 233**
**A2**

## (12) EUROPÄISCHE PATENTANMELDUNG

(21) Anmeldenummer: **84890066.8**

(22) Anmeldetag: **05.04.84**

(51) Int. Cl.³: **F 16 L 27/08**
**B 26 F 3/00**

(30) Priorität: **07.04.83 AT 1232/83**

(43) Veröffentlichungstag der Anmeldung:
**14.11.84 Patentblatt 84/46**

(84) Benannte Vertragsstaaten:
**BE CH DE FR GB IT LI LU NL SE**

(71) Anmelder: **VEREINIGTE EDELSTAHLWERKE AKTIENGESELLSCHAFT (VEW)**
**Elisabethstrasse 12**
**A-1010 Wien(AT)**

(72) Erfinder: **Trieb, Franz**
**Joh. Böhm-Strasse 40/14**
**A-8605 Kapfenberg(AT)**

(72) Erfinder: **Windisch, Franz**
**Joh. Böhm-Strasse 45**
**A-8605 Kapfenberg(AT)**

(74) Vertreter: **Widtmann, Georg, Dr.**
**Vereinigte Edelstahlwerke Aktiengesellschaft (VEW)**
**Elisabethstrasse 12**
**A-1010 Wien(AT)**

### (54) Drehdurchführung.

(57) Die Erfindung betrifft eine Drehdurchführung zur Führung von unter hohem Druck, insbesondere bis zu 5000 bar, vorzugsweise von 500 bis 4000 bar, stehenden flüssigen Medien durch im wesentlichen miteinander fluchtende Achsen aufweisende, gegeneinander verdrehbare Rohrteile (1, 2) für Flüssigstrahl-Schneideinrichtungen, mit einen Führungskanal (110) für das Medium aufweisendem Gehäuseteil (1) und einem mit seinem Mediumsführungskanal (210) an den Gehäusekanal (110) im wesentlichen achsfluchtend anschließenden und am bzw. im Gehäuseteil (1) im wesentlichen um die Gehäuseachse drehbar gelagerten Drehkörper (2), wobei Gehäuseteil (1) und/oder Drehkörper (2) zusätzlich über mindestens eine, auf ihm bzw. ihnen angeordnete oder mit ihm bzw. ihnen in kraftschlüssiger Verbindung stehende, bevorzugt nach außen weisende, vorzugsweise zylindermantelförmige, Führungsfläche (141, 142) und mindestens eine, entsprechend ausgebildete, der Führungsfläche (141, 142) zugekehrte, mit ihr kooperierende Führungsfläche (151, 152) mindestens einer im wesentlichen koaxial mit den genannten Teilen (1, 2) angeordneten Hülse (15) in dieser Hülse (15) im wesentlichen um die gemeinsame Achse (A) drehbar gelagert ist, bzw. sind.

Fig. 2

Drehdurchführung

Die Erfindung betrifft eine Drehdurchführung zur Führung eines unter hohem Druck von bis zu 5000 bar stehenden flüssigen, Mediums durch zwei im wesentlichen miteinander fluchtende Achsen aufweisende, gegeneinander verdrehbare Rohrteile. Die Drehdurchführung ist besonders für Flüssigstrahl-Schneideinrichtungen vorgesehen.

Üblicherweise ist bei drehbaren Rohrverbindungen ein Rohrteil als mit einem Anschlußelement an eine Medium-Zuführleitung ausgestattetes, einen, meist zentralen, Kanal zur Führung der Flüssigkeit aufweisendes Gehäuse ausgebildet, an bzw. in welchem ein mit seinem Führungskanal an den Gehäusekanal achsfluchtend anschließender, um die gemeinsame Achse drehbar gelagerter Rohrteil, ein sogenannter Drehkörper, angeordnet ist, der seinerseits ebenfalls zumindest ein Element für den Anschluß an eine weiterführende Leitung, eine Arbeitsdüse, eine Turbine od. dgl. aufweist. Meist ist das Gehäuse mit einer feststehenden Zuleitung verbunden, während der Werkzeugkopf, z.B. eine Strahldüse, mit dem drehbaren Rohrteil, also dem Drehstück verbunden ist. Die beiden Rohrteile können ohne weiteres auch in umgekehrter Reihenfolge angeordnet sein. Es ist aber auch möglich, die Drehverbindung selbst,also deren Gehäuse und/oder Drehkörper beliebig gegeneinander und an den Anschlußstücken verdrehbar auszubilden.

Es existiert eine große Zahl von allgemeinen Vorschlägen für von flüssigen Medien durchsetzte, dreh- oder schwenkbare Rohrverbindungen für Einsätze auf verschiedenen Gebieten.

So ist in der AT-PS 258.059 ein schwenkbares Auslaufrohr für sanitäre Armaturen beschrieben, bei welchem der schwenkbare Auslaufteil eine Sicke zur Aufnahme eines schließlich von einer Überwurfmutter gehaltenen Dichtungsringes aufweist.

Bei einer in der AT-PS 169.227 beschriebenen Rohrverbindung sind feststehender und schwenkbarer Rohrteil aneinander stumpfstoßend ausgebildet, wobei beide Rohrteile jeweils nach außen abgesetzte Enden aufweisen und dort in einer den durch die Absetzungen sich ergebenden Raum ausfüllenden Muffe mittels, z.B. durch eine Kugelkette gebildeter, Wälzlagerung gelagert sind.

Bei der in der AT-PS 221.884 beschriebenen, drehbaren, für Druckleitungen geeigneten Rohrverschraubung ist ein Zuleitungsstück mit einem Führungszapfen vorgesehen, der von einem auf ihm drehbar gelagerten Ableitungsstück umgeben ist, wobei das drehbare Stück auf einem mittels Überwurfmutter gehaltenen Axial-Wälzlager gelagert und gehalten ist.

Den beiden AT-PS 232.330 und 245.879 sind drehbare Rohrverbindungen mit Dichtungsanordnungen zu entnehmen, bei denen die relativ zueinander verdrehbaren Rohrteile aufeinander mittels Kugellager gelagert sind und miteinander eine sich radial nach innen öffnende Nut bilden, in welcher ein in axialer Richtung wirksamer Dichtungsring eingesetzt ist.

Schließlich sind aus den AT-PS 214.726, 232.331 und 236.717 dreh- und schwenkbare Rohrverbindungen bekannt geworden, bei welchen einer der Rohrteile auf zwei in einem ihn umgebenden, mit dem anderen Rohrteil verbundenen Lagerhalterungs-Gehäuse untergebrachten Wälzlagern gelagert ist, wobei zwischen den Stirnflächen der beiden Rohrteile ein die Abdichtung nach außen gewährleistender, flacher Dichtungsring angeordnet ist, der mit axial wirkender Kraft gegen die Stirnfläche des anderen Rohrteiles gepreßt ist.

In den letzten Jahren hat sich das randsaubere Schneiden und Trennen verschiedener Materialien mit einem aus einer Düse mit hoher Geschwindigkeit austretenden Strahl eines unter hohem Druck im Bereich von mehreren hundert bis 5000 bar, insbesondere 1500 - 4000 bar, stehenden flüssigen Mediums, meist Wasser, durchgesetzt, und es besteht das Bestreben, derartige Strahl-Schneideinrichtungen hinsichtlich der Ausrichtung des Schneid-Strahles möglichst flexibel und an den Einsatz angepaßt zu gestalten, sodaß insbesondere für handgeführte Schneidapparate handhabungssichere Drehdurchführungen von Interesse sind. An die Konstruktionen ist die Forderung gestellt, die Teile der Hochdruck-Rohrleitung mehr oder weniger schnell gegeneinander drehbar zu gestalten, und darüber hinaus soll die Drehverbindung auch beim rauhen Betrieb bruchsicher sein. In vielen Fällen sollen Bewegung und Ausrichtung der Strahldüse und damit des Schneidstrahles in allen drei Raumrichtungen erfolgen können. Es besteht zur Erreichung dieses Zieles die Forderung, bei den verdrehbaren Rohrteilen trotz der hohen Drücke jegliche Leckage zu vermeiden und bei schlanker Bauweise der Drehverbindungen ein reibungsarmes Drehen der Rohrteile zu gewährleisten, wobei gleichzeitig die bei Manipulation und händischem Ausrichten sowie Bewegen der Strahldüse auf die drehbaren Rohrteile einwirkenden Biegekräfte nicht zu groß sind und zu einem Brechen oder Knicken der Rohrverbindung führen. Darüber hinaus soll weiters gewährleistet sein, daß im Falle eines dennoch auftretenden Risses oder Bruches das Bedienungs-

- 4 -

personal nicht durch einen unter hohem Druck austretenden
Mediums-Strahl oder von weggeschleuderten Teilen einer
berstenden Apparatur gefährdet wird. Schließlich soll die
Drehdurchführung zur Erleichterung der Handhabung und
Lageeinstellung eines Düsenkopfes möglichst schlanke Bauweise und außerdem hohe Verschleißsicherheit gewährleisten.

Abgesehen davon, daß bisher bekannt gewordene dreh- und
schwenkbare Rohrverbindungen zur Führung flüssiger Medien,
insbesondere hinsichtlich Aufrechterhaltung der Dichtigkeit nicht voll imstande sind, den hohen Medium-Drücken
in Größenordnungen bis zu 5000 bar über längere Betriebsdauer standzuhalten, haben sie, wenn sie für höhere Drucke
ausgelegt sind, den großen Nachteil einer plumpen Bauweise, sodaß sie sich für sicher und leicht zu führende
Handgeräte zum Flüssigstrahl-Schneiden nicht eignen.

Aufgabe der vorliegenden Erfindung ist daher die Schaffung
einer Drehdurchführung, welche die genannten Nachteile
nicht aufweist, deren Konstruktion relativ einfach und
robust ist, und welche einen optimalen Schutz einer möglichst schlank konstruierten drehbaren Rohrverbindung vor
extremer Biegebeanspruchung, z.B. bei abruptem händischem
Lagewechsel des Düsenkopfes, und außerdem einen praktisch
absoluten Schutz des Bedienungspersonal vor Verletzungen
bei plötzlichem Austreten der Flüssigkeit bei einem Bersten
der Drehverbindung gewährleistet. Trotz Anordnung von
solche Vorteile bietenden Stütz- und/oder Schutzelementen
soll das Manipulieren nicht behindert werden. Nicht zuletzt soll die Apparatur ein gefälliges Aussehen haben.

Gegenstand der Erfindung ist somit eine Drehdurchführung
zur Führung eines unter, vorzugsweise bis zu 5000 bar, insbesondere von 500 bis 4000 bar, stehenden flüssigen Mediums durch zwei im wesentlichen miteinander fluchtende Achsen aufweisende, gegeneinander verdrehbare Rohrteile für Flüssigstrahl-Schneideinrichtungen, mit einen Führungskanal für das Medium aufweisendem Gehäuseteil und einem mit seinem Mediums-Führungskanal an den Gehäusekanal im wesentlichen achsfluchtend anschließenden und am bzw. im Gehäuseteil im wesentlichen um die Gehäuseachse drehbar gelagerten Drehkörper, die dadurch gekennzeichnet ist, daß Gehäuseteil und/oder Drehkörper zusätzlich über mindestens eine, auf ihm bzw. ihnen angeordnete oder mit ihm bzw. ihnen in kraftschlüssiger Verbindung stehende bevorzugt nach außen weisende, vorzugsweise zylindermantelförmige, Führungsfläche und mindestens eine, entsprechend ausgebildete, dieser Führungsfläche zugekehrte, mit ihr kooperierende Führungsfläche mindestens einer im wesentlichen koaxial mit den genannten Teilen angeordneten Hülse in dieser Hülse im wesentlichen um die gemeinsame Achse drehbar gelagert ist, bzw. sind. Das Wesen der Erfindung sei anhand einer einfach aufgebauten Drehdurchführung erläutert: An einem Ende der Durchführung ist auf deren Gehäuse außen eine periphere zylindrische oder, anders rotationssymmetrische, z.B. kegelige oder sphärische Drehführungsfläche angeordnet und am anderen Ende der Durchführung an dem drehbar im Gehäuse gelagerten,weiterführenden Rohrstück- hier als "Drehstück" bezeichnet - eine ebensolche Führungs- oder Lagerungsfläche. Die Rohrteile, also Gehäuse und Drehstück, sind über ihre Führungsflächen an entsprechend geformten, mit ihnen kooperierenden Gegenführungsflächen einer im wesentlichen beide Rohrteile umschließenden Führungs-, Stütz- und Schutz-Hülse drehbar gelagert. In diesem einfachen Beispielsfalle ist die Schutzhülse - im wesentlichen unabhängig von der relativen Drehung von Gehäuse und Drehstück - ebenfalls um die Achse der gesamten Drehdurchführung drehbar, und hilft gleichzeitig mit, Gehäuse und darin gelagertes drehbares Rohrstück in der gewünschten achsfluchtenden Lage auch dann zu halten, wenn quer zur Achse Kräfte angreifen und zu Biegebeanspruchung führen, wie das z.B. beim Führen des Düsenkopfes mittels der mit ihm verbundenen Führungs-Handgriffe beim händischen Hochdruck-Strahlschneiden entlang kurviger oder eckiger Konturen oder auch bei Positionseinstellung vor Einschaltung des Hochdruck-Strahlmediums der Fall ist. Es kann weiters vorgesehen sein, daß die Führungsflächen nicht direkt am Gehäuse und/oder Drehstück angeordnet sind, sondern beispielsweise an mit diesem verbundenen Anschluß-, Zwischen- und/oder Verbindungs-Teilen, -Stücken oder -Elementen, wobei diese, vorzugsweise lösbar, mit Gehäuse und/oder Drehstück verbunden sind, was Montage und Austausch erleichtert. ·

So ist z.B. eine Bauweise vorteilhaft, bei der die mindestens eine Drehführungsfläche aufweisende Hülse mit Gehäuse oder Drehkörper über ein, vorzugsweise lösbar mit ihm verbundenes, gegebenenfalls als von einem abgewinkelten Kanal durchsetztes Winkelstück ausgebildetes, Zwischenstück verbunden ist. Dadurch ist eine sehr stabile Verbindung zwischen vorteilhafterweise rohrartiger Stütz-Hülse und Gehäuseteil bzw. Drehstück geschaffen, bei der die Hülse nicht direkt am Drehstück oder Gehäuse drehbar gelagert ist, und diese stützt. Damit ist sie unabhängig von diesem und kann leichter montiert werden, was insbesondere bei einem Austausch von Teilen Vorteile bringt.

Eine weitere günstige Ausführungsform sieht vor, daß Drehkörper oder Gehäuseteil einen, gegebenenfalls über Verbindungs- Düsen-Anschluß- und/oder Zwischenstück(e), vorzugsweise lösbar, mit ihm verbundenen hülsenartigen Fortsatz mit mindestens einer von der Achse weg nach außen

gerichteten ,vorzugsweise zylindermantelförmigen, Führungsfläche aufweist, die mit mindestens einer entsprechenden,
ihr zugekehrten Führungsfläche einer den genannten Fortsatz umgebenden, jeweils mit Gehäuseteil oder Drehkörper,
gegebenenfalls über Verbindungs-, Anschluß-, und/oder
Zwischenstücke, vorzugsweise lösbar, verbundenen Hülse
kooperiert. Diese Ausbildungsform hat den Vorteil, daß
infolge der Innenführung von, vorteilhaft etwa rohrartig ausgebildetem ,hülsenartigem Fortsatz und ,ebenfalls
bevorzugt rohrartiger, Hülse selbst eine teleskop-artige
Panzerung der sonst biegebeanspruchten Teile einer Drehdurchführung erreicht wird, was deren Sicherheit wesentlich erhöht. Infolge der in ihrer Ausdehnung jeweils den
Anforderungen entsprechend wählbaren Überlappungsbereiche
von hülsenartigem Fortsatz und diesen umgreifender Hülse,
wo die ineinader drehende Lagerung von Hülse und Fortsatz
über ihre Führungs- bzw. Lagerungsflächen erfolgt, wird eine
optimale Führung und damit verquerungssichere, reibungsarme und gleichzeitig hohe Verwindungs- und Biegesteifigkeit
besitzende Drehverbindung erreicht . Darüber hinaus lassen
sich schlanke Bauweise und ansprechendes  Äußeres sowie
bequeme Handhabung erzielen.

Vorteilhaft sind Hülse und/oder hülsenartiger Fortsatz
aus verschiedenen hochfesten Materialien gefertigt, z.B.
ist die Materialkombination Bunt- bzw. Lagermetall und
Stahl bevorzugt. Damit sind die aneinander gleitend geführten Drehführungsflächen aus verschiedenen Materialien,
und ein Verreiben der Bauteile ist praktisch ausgeschlossen.

Eine besonders bevorzugte Ausführungsform der eben beschriebenen, mit etwa teleskop-artiger Stützhülse ausgestatteten Drehdurchführung ist dadurch gekennzeichnet,
daß der hülsenartige Fortsatz zumindest im Bereich seines Randes einen von der Achse (A) weg radial nach außen
weisenden Vorsprung mit zusammen mit einer Führungsfläche
der umgebenden Hülse kooperierender Führungsfläche und die
Hülse zumindest im Bereich ihres Randes einem radial nach
innen zur Achse (A) hin gerichteten Vorsprung mit zusammen
mit einer Führungsfläche am Außenmamtel des hülsenartigen
Fortsatzes kooperierender Führungsfläche aufweisen, und
die Vorsprünge, gegebenenfalls im Abstand voneinander,
in Achsrichtung einander zugekehrte, vorzugsweise im
wesentlichen normal zur Achse (A) sich ersteckende, ringartige Anschlagflächen aufweisen. Die beiden richtungsmäßig zueinander gekehrten radialen Vorsprünge bewirken,
daß im Falle einer Kraftwirkung in Achsrichtung, z.B.
bei Bruch des Rohres des Drehstückes, ein axiales Auseinanderschleudern der Einzelteile der Drehverbindung verhindert wird, da über die zwischen den beiden genannten
Anschlagflächen der teleskop-artigen Hülse vorgesehene
Distanz hinaus eine axiale Bewegung nicht erfolgen kann.
Neben dieser weiteren Sicherung der Drehverbindung in
axialer Richtung bewirken die genannten Vorsprünge eine
besondere Stabilisierung des teleskop-artigen "Stütz- und
Schutzpanzers" der Drehverbindung.

In vorteilhafterweise sind Hülse und/oder hülsenartiger
Fortsatz an einem mit dem Gehäuse und/oder dem Drehstück,
gegebenenfalls über mindestens ein Zwischen- bzw. Verbindungsstück, wie z.B. Druckschraube mit Druckring oder
dgl.,lösbar verbundenen Zwischenstück angeordnet, bzw.
mit diesem verbunden, welches,bevorzugt von einem,vorzugsweise etwa 90-grädig, abgewinkelten, Kanal zur Führung
des Hochdruckmediums durchsetzt, als Winkelstück, Anschlußstück oder Düsenstück ausgebildet sein kann. Vorteil
dieser Verbindung von jeweils die Drehführung des Stützpanzers tragender Hülse und hülsenartigem Fortsatz mit den genannten Zwischen- bzw. Winkelstücken ist der, daß die Stabilität der Drehdurchführung erhöht ist, wobei ein direktes Angreifen der drehbaren "Stützpanzerung" an den Grundbausteinen der eigentlichen Drehverbindung vermieden und Fertigung und Montage sowie Austausch von Teilen erleichtert sind.

Die mit Hülse und, vorzugsweise hülsenartigem, Fortsatz abgestützte und an deren Führungsflächen gleitend drehbar gelagerte und geführte Drehverbindung weist günstigerweise einen Gehäuseteil mit, vorzugsweise mit Anschlußelement, wie z.B. Verbindungsgewinde ausgestattetem Gehäusebasisteil mit Kanal, in diesen eingesetztem Lagerteil und lösbar mit ihm verbundenem Lagerhalte-Teil mit Lager und einen mit seiner Achse mit der Achse des Gehäuseteiles fluchtenden, von einem Kanal durchsetzten Drehkörper mit in einer entsprechenden Ausnehmung des Lagerteiles drehbar gleitgelagertem Kanalfortsatz, am vom Lagerhalte-Teil des Gehäuseteiles gehaltenen Lager sich in axialer Richtung abstützendem, radialem, Lagerhaltevorsprung und einem Verbindungsstück, vorzugsweise Druckschraube mit Druckring auf. Diese zuletzt beschriebene Bauweise der Drehdurchführung zeichnet sich dadurch aus, daß sie trotz Einfachheit eine höchstdruckfeste, die unbehinderte Verdrehbarkeit in alle Lagen gewährleistende, leckagesichere Führung eines unter bis zu einigen Tausend bar Druck stehenden Mediums ermöglicht, wobei gleichzeitig eine platzsparende kraftschlüssige, lösbare Verbindung von erfindungsgemäß vorgesehener Hülse und hülsenartigem Fortsatz mit Gehäuse und Drehstück möglich ist.

Bevorzugt ist bei der Dichtung für das Drehstück vorge- sehen, daß der Kanalfortsatz des Drehkörpers gegen das Innere des Gehäusebasisteiles mittels vom Lagerteil, insbesondere Druckschraube, gepreßter Dichtung mit ,vorzugsweise zwischen Dichtungshaltern angeordnetem, Dichtungsring abgedichtet ist. Diese Dichtung zeichnet sich durch einfachen Aufbau und hohe Leckagesicherheit aus.

Besonders bevorzugt ist es, wenn der Dichtungsring im wesentlichen trapezförmigen Querschnitt aufweist, wobei die lange Basisseite am Kanalfortsatz des Drehstückes anliegt.

Vorteilhaft schließen die beiden Trapezflanken des Ringes mit seiner Basis einen Winkel zwischen 60 und 85°, insbesondere zwischen 75 und 85°, ein. Durch die Schräge der Flanken wird zusammen mit einer über beidseitig angeordnete Dichtungshalter, bewirkten axialen Pressung des Dichtringes ein besonders sattes radiales, lecksicheres Anpressen und Anliegen des Ringes an der Außenfläche des im Lagerteil des Gehäuses gleitgelagerten Kanalfortsatzes des Drehstückes erreicht. Vorteilhaft sind der Lagerteil, der bevorzugt durch eine in dem Gehäuseteil aus hochfestem Stahl eingeschraubte Lager-Druckschraube gebildet ist, aus Buntmetall, z.B. hochfestem Lagermetall ,und der Gehäuseteil sowie der in dem Lagerteil mit seinem Kanalfortsatz drehbar gleitgelagerte Drehkörper aus Stahl, insbesondere hochfestem Sonderstahl, gefertigt. Wie schon oben erwähnt, ist bzw. sind vorteilhafterweise Gehäuse und/oder Drehstück, gegebenenfalls über Verbindungsstück(e), jeweils mit einem als Winkelstück mit abgewinkeltem Führungskanal ausgebildeten Zwischenstück verbunden, das jeweils seinerseits mit einer weiteren Drehdurchführung, also mit deren Gehäuseteil und/oder Drehstück verbunden ist, womit beispielsweise eine mehr als ein-dimensionale Bewegung und Ausrichtung des die Drehverbindung verlassenden Stahles, mittels dem Düsenkopf einer Hochdruck-Schneideinrichtung ermöglicht ist.

Insbesondere auch aus Gründen einer vereinfachten Fertigung und Wartung ist es vorteilhaft, jeweils die Winkelstücke so auszubilden, daß die entweder nur mit, vorzugsweise gleichartigen,Gehäuseteile oder nur mit, vorzugsweise gleichartigen,Drehstücken, jeweils gegebenenfalls über Verbindungsstücke, verbindbar sind. An dieser Stelle sei wiederholend betont, daß Gehäuseteil und Drehstück der erfindungsgemäßen Drehdurchführung unabhängig von der Fließrichtung der sie durchströmenden Strahlflüssigkeit angeordnet sein können.

Schließlich ist es zur Ausbildung einer in alle drei Raumrichtungen frei bewegbaren Durchführung von unter hohem Druck stehenden Flüssigkeiten, wie sie insbesondere für hand- oder prozessor-bediente Strahlschneidgeräte vorteilhaft ist, günstig, drei wie oben im einzelnen beschriebene, mit Führungs-, Stütz- und Schutzhülsen ausgestattete, vorzugsweise gleichartige, Drehdurchführungen vorzusehen , wobei diese über zwei sie verbindene, vorzugsweise 90-grädig abgewinkelte Führungskanäle für das Strahlmedium aufweisene Winkelstücke, bezogen auf ihre Achsen jeweils aufeinander normal angeordnet sind. Eine derartig ausgebildete Drehdurchführung ist infolge der seriellen Anwendung gleichartiger Elemente kostengünstig und erlaubt ein vollkommen unbehindertes Ausrichten des Strahles, wobei auch rasche und abrupte Bewegungsabläufe keine Rolle spielen, da dabei auftretende, die Rohrverbindungen gegebenenfalls gefährdende Biegekräfte von der hülsenartigen Stütz- und Schutzpanzerung abgefangen und aufgenommen werden.

Anhand der Zeichnung wird im folgenden die Erfindung näher erläutert.

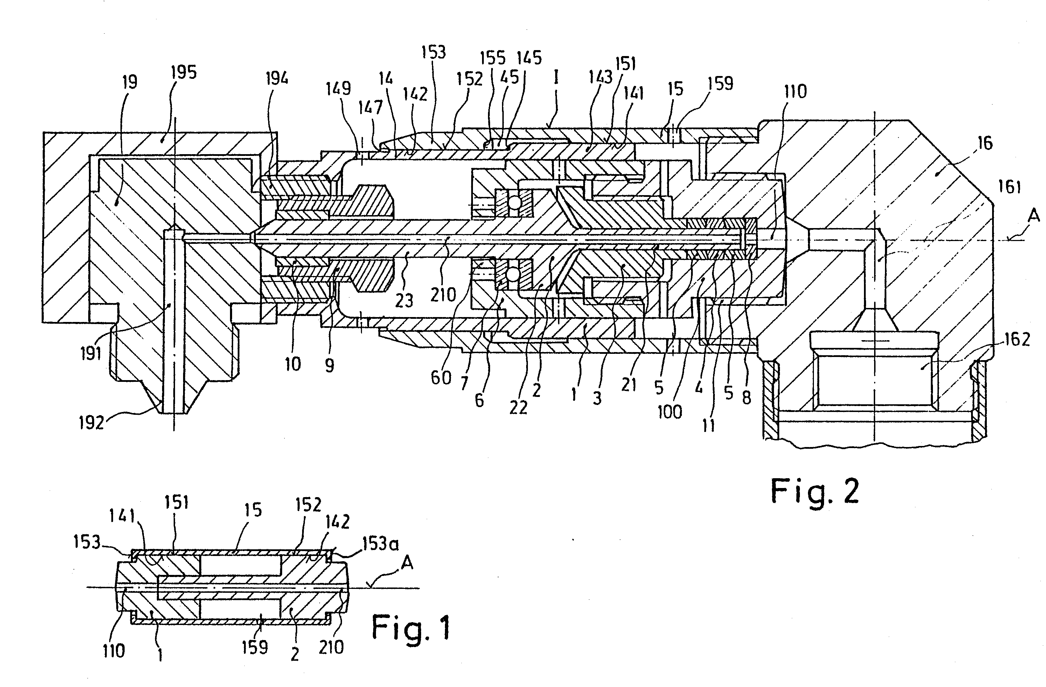

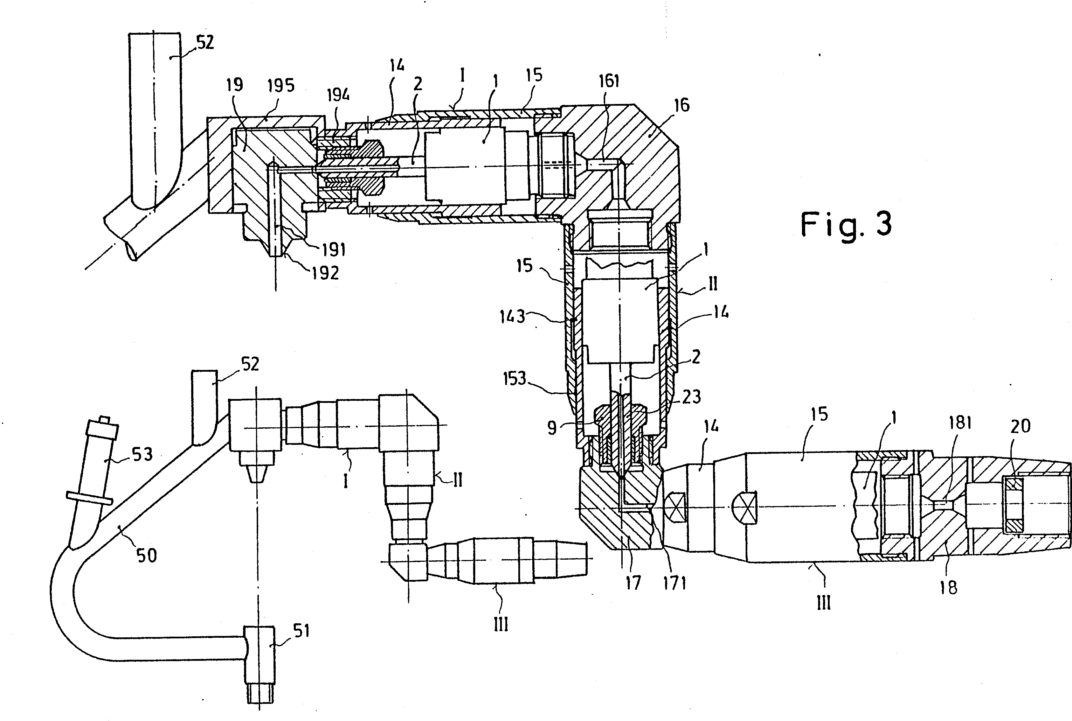

Es zeigen Fig. 1 die schematische Skizze einer erfindungsgemäßen Drehdurchführung in einfachster Form, Fig. 2 den
Schnitt durch eine erfindungsgemäße Drehverbindung eines
handgeführten Flüssigstrahl-Schneidegerätes und Fig. 3
ein derartiges Schneidegerät mit in alle Richtungen des
Raumes frei bewegbarem Düsenkopf der an einer Kombination
von drei an ein nicht gezeigtes, übliches Hochdruck-Mediums-
Zuführungssystem anschließbaren, erfindungsgemäß ausgebildete
Drehverbindungen angeordnet ist.

Bei der in Fig. 1 nur prinziphaft gezeigten Drehverbindung I ist der einen Zuführungskanal 110 aufweisende,
als Gehäuseteil 1 ausgebildete Rohrteil gezeigt, in dessen
zentraler Ausnehmung ein einen zentralen Kanal 210 aufweisendes, den zweiten Rohrteil bildendes Drehstück 2 gleitgelagert ist. Gehäuseteil 1 und Drehstück 2 weisen nach
außen hin zylindrische Führungsflächen 141, 142 auf, welche
mit entsprechenden, ebenfalls zylindrischen, zur Achse A
weisenden Führungsflächen 151, 152 einer sowohl Gehäuseteil als auch Drehstück umgebenden Führungs-, Schutz- und
Stütz-Hülse 15 kooperieren. Diese weist nach innen gebogene
Fortsätze 153, 153a auf, welche eine axiale Auseinanderbewegung von Gehäuse und in ihm gelagertem Drehstück 2 verhindern. In der Hülse 15 sind Öffnungen 159 angeordnet,
welche im Falle eines Berstens oder Leckes der Rohrverbindung ein gefahrloses, weil druckloses Ableiten des
Strahlmediums ermöglichen.

In der Fig. 2 ist eine in der Praxis bewährte, gegen seitliche Biegebeanspruchung unempfindliche, montagefreundliche,erfindungsgemäße Drehverbindung I gezeigt. In einem
einen zentralen Führungskanal 110 aufweisenden Gehäusebasisteil 100,einen in dessen zentraler Ausnehmung angeordneten Lagerteil 3- in der gezeigten Anordnung eine sogenannte Lager-Druckschraube - und einen Lagerträgerteil 6 umfassenden Gehäuseteil 1 ist das Drehstück 2 mit in der zentralen Ausnehmung des Lagerteiles 3, um die Achse A drehbar gleitend gelagertem Kanalfortsatz 21, daran anschließendem Lagerhaltevorsprung 22 und dem weiterführendem Rohrstutzen 23, der im Bereich seines Endes eine Verbindungsschraube 9 mit Druckring 10 trägt, gelagert angeordnet. Das Drehstück 2, das bevorzugt aus einem Sonderstahl mit Festigkeit bis 1500 N/mm$^2$ gefertigt ist, weist einen, es zentral durchsetzenden Führungskanal 210 für das Medium auf, welcher mit dem Kanal 110 im Gehäusebasisteil 100 achsfluchtend ist, und schließt sich an den genannten Kanal unter Zwischenschaltung einer Druckscheibe 8 an. In seinem Endbereich ist der Kanalfortsatz 21 durch einen zwischen Dichtungshaltern 5 angeordneten Dichtungsring 4 mit trapezförmigem Querschnitt, welche Teile in zentraler Ausnehmung des Gehäusebasisteiles 100 angeordnet sind, abgedichtet, wobei die genannte Kombination aus Haltern 5 und Ring 4 mittels der Lager-Druckschraube 3, die vorteilhaft aus Buntmetall gefertigt ist, in axialer Richtung gegen die an den Kanal 110 des Gehäuseteiles 1 anschließende Druckscheibe 8 gepreßt ist. Damit ist eine hochdruck-lecksichere Dichtung des drehbaren Rohrteiles 2 im Gehäuseteil 1, die an sich einfach gebaut ist, erreicht. In Achsrichtung in Lage gehalten wird das Drehstück 2 durch ein an dem Fortsatz 60 des Lagerhalteteiles 6 des Gehäuseteiles 1 abgestütztes und sich am Lagerhaltevorsprung 22 des Drehstückes 2 abstützendes Wälzlager 7. In dem Gehäuse sind weiters nicht näher bezeichnete Kanäle zur druckgeminderten Abführung von Medium im Falle eines Berstens, bzw. zur Montageerleichterung vorgesehen. Der Gehäusebasisteil 100 ist über Verbindungselemente, im gezeigten Fall eine Gewindeverbindung 11, mit dem einen rechtwinkelig geknickten Kanal 161 aufweisenden Zwischenstück, dem sogenannten Winkelstück 16 mit einer Ausnehmung 162, in welche ein
Gehäuseteil einer weiteren Drehverbindung eingesetzt
werden kann,lösbar verbunden. Der weiterführende Rohrstutzen 23 des Drehstückes 2 ist über die Druckschraube 9
in der gezeigten Anordnung mit dem Verbindungsteil 194
und Umhüllungsgehäuse 195 eines Düsenkopfes 19 mit zentralem,
ebenfalls 90-grädig gewinkelten Verlauf aufweisenden
Führungskanal 191 und Strahldüse 192 verbunden, wobei Teil 194
weiters über eine lösbare Gewindeverbindung mit einem hülsenartigen zylindrischen Fortsatz 14 mit einem Vorsprung 143
mit von der Achse weg weisender Führungsfläche 141 verbunden ist. An der Außenmantelfläche, die an der den Düsenkopf 19 näheren Seite keinen eigenen Vorsprung aufweist,
ist eine weitere Drehführungsfläche 142 angeordnet. Den
genannten Fortsatz 14 des Drehkörpers 2 umgreifend ist
eine mit dem vorher beschriebenen,den Gehäuseteil 1 tragenden
Winkelstück 16 verbundene Hülse 15 angeordnet, welche jeweils mit den Flächen 141 und 142 des Fortsatzes 14 auf
diesen zylindrischen Flächen gleitlagernd kooperierende
Führungsflächen 151, 152 aufweisen, wobei die letztgenannte
Führungsfläche 152 auf einem zur Achse A der Anordnung hin
radial nach innen weisenden Vorsprung 153 angeordnet ist,
während die am Innenmantel der Hülse 15 angeordnete zweite
Fläche 151 mit der Führungsfläche 141 am Fortsatz 14 gleitgelagert kooperiert. Zwischen den beiden genannten Vorsprüngen 153, 143 von teleskopartig ineinander drehbar gelagertem Fortsatz 14 und ihn umgreifender Hülse 15 ist
zwischen Innenwand von Hülse 15 und Außenwand von Fortsatz
14 und den beiden einander zugekehrten Flanken von deren
Vorsprüngen 153, 143 ein Distanz-Raum 45 ausgebildet. Im
Abstand voneinander sind an den genannten Flanken der beiden
Vorsprünge einander zugekehrte Anschlagflächen 145 am Vorsprung 143,und 155 am Vorsprung 153 in Distanz voneinander
angeordnet. Nur um diese Distanz können im Falle eines Aus-

trittes von Medium bei einem Bersten der Rohrverbindung Stütz-Hülse 15 und Fortsatz 14 in axialer Richtung auseinandergeschoben werden, sodaß ein Bedienungspersonal gefährdendes Auseinanderschleudern von Apparaturteilen und Austreten von unter hohem Druck stehenden Strahlmedium sicher vermieden wird und ein gewöhnlicher Druckausgleich stattfindet. Außerdem sind jeweils in Hülse 15 und hülsenartiger Fortsatz 14 im wesentlichen radial nach außen gerichtete Entlastungsöffnungen 159, 149 angeordnet, welche ein praktisch druckloses Ableiten des Mediums im Falle eines Risses oder Bruches ermöglichen. Um ein Verreiben von Hülse 15 und Fortsatz 14 zu vermeiden, sind sie vorteilhaft aus verschiedenen Materialien,z.B. aus Buntmetall und Stahl, gefertigt, weiters ist zwischen Hülse 15 und Fortsatz 14 ein frontaler Ring-Schlitz 147 vorgesehen. Es sei betont, daß die erfindungsgemäße Drehverbindung nicht auf im wesentlichen zylindrische, miteinander teleskopartig kooperierende Stützung mit Fortsatz 14 und Hülse 15 beschränkt ist, es ist auch nicht zwingend, daß gerade die Hülse mit dem Gehäuseteil 1 und der Fortsatz mit dem Drehstück verbunden ist, selbstverständlich ist eine Umkehrung nicht ausgeschlossen. Zusammenfassend ist festzuhalten, daß neben der schon durch die drehende und gegen Leckage gesicherten Ineinanderlagerung von Gehäuseteil 1 und Drehstück 2 zusätzlich eine stützende Lagerung dieser beiden Rohrverbindungs-Teile über die kooperierenden Führungsflächen von günstigerweise vorgesehenem Fortsatz 14 und Hülse 15,die jeweils mit den genannten Teilen 1,2 verbunden sind,gewährleistet ist. Wesentlich ist jedenfalls, daß stabilisierend kooperierende Führungsflächen vorgesehen sind, welche gegebenenfalls andere rotationssymmetrische Form und Gegenform aufweisen können, und nicht auf im wesentlichen geschlossenen Mantel aufweisenden Hülsen angeordnet sein müssen. Es sind auch käfigartige Konstruktionen od. dgl. möglich, welche die genannten Führungsflächen tragen. Nachteilig ist allerdings in diesem Falle, daß bei Austritt von Medium die Schutzfunktion der Stützelemente wegfällt und nur deren Stützfunktion und die Vermeidung einer Bruchgefährdung durch Biegebanspruchung erfüllt wird. An die Oberflächenbearbeitung der Führungsflächen 141, 142, 151 und 152 auf Fortsatz 14 und Hülse 15 sind keine besonderen Anforderungen gestellt, wenn nur eine einigermaßen paßgenaue, drehsichere, verschleißarme Führung der beiden Teile gewährleistet ist. Es sei hier festgehalten, daß die erfindungsgemäße Anordnung einer zusätzlichen Lagerung der Rohrteile eine Entlastung auch hinsichtlich Verschleiß der Rohrverbindung bringt und damit wesentliche Standzeiterhöhungen erreicht werden können.

Fig. 3 zeigt eine Kombination von drei erfindungsgemäßen Drehdurchführungen I, II, III, welche jeweils aufeinander senkrecht stehende Achsen aufweisend, miteinander über zwei Winkelstücke 16, 17 verbunden sind, und die für ein in alle drei Richtungen des Raumes frei bewegbares Handgerät zum Flüssigstrahlschneiden geeignet ist. Das gesamte Strahlführungssystem ist über das rechts unten im Schnitt gezeigte Anschlußstück 18 mit Druckscheibe 20 an eine übliche Hochdruckzuführung für das flüssige Strahlmedium angeschlossen. Das Anschlußstück 18 ist mit der dritten Drehverbindung III mit auf es aufgeschraubter Hülse 15 und mit ihm verbundenem Gehäuseteil 1 verbunden. Der in der Hülse 15 gelagerte hülsenartige Fortsatz 14 ist seinerseits mit einem, einen in rechtem Winkel abgewinkelten Führungskanal 171 aufweisenden Winkelstück 17 verbunden, in das seinerseits das weiterführende Rohrstück 23 des Drehstückes 2 einer Drehverbindung II über eine Druckschraube 9 eingeschraubt ist und das weiters den Fortsatz 14 dieser zweiten Drehverbindung II trägt, welcher von der Hülse 15, die ihrerseits mit einem zweiten Winkelstück 16, welches auch den Gehäuseteil 1 trägt, verbunden ist, teleskopartig umgriffen ist. Hülsenartiger Fortsatz 14 und Hülse 15 von II kooperieren über die an ihren einander zugekehrten Vorsprüngen 143, 153 angeordneten Drehführungsflächen miteinander. Das zweite Winkelstück 16 weist ebenfalls einen rechtwinkelig abgewinkelten Führungskanal 161 auf, und trägt seinerseits wieder außer einem Gehäuseteil 1 weiters eine Hülse 15, einer ersten Drehverbindung I , welche den dazugehörigen Hülsenfortsatz 14 ebenfalls teleskopartig umgreift. Letztgenannter ist über ein Verbindungsstück 194 mit dem Drehstück 2 mit Druckschraube 9 einerseits und der Hülle 195 des Düsenstückes 19 mit ebenfalls abgewinkeltem Kanal 191 verbunden. Der abgewinkelte Kanal 191 des Düsenstückes 19 endet im Strahldüsenanschlußstück 192, aus welchem der Schneid-Strahl mit einigen tausend bar Druck über eine nicht gezeigte Düse, austritt. In Verbindung mit dem Düsenkopf 19 ist weiters ein Bügel 50 mit zur Düsenachse achsgleich ausgerichtetem Strahlfänger 51. Der Bügel 50 trägt weiters ein Rohrstück 52 sowie einen mit nicht näher bezeichneten Bedienungselementen versehenen Handgriff 53. Mittels dieses Handgriffes 53 läßt sich der Düsenkopf 19 und damit die Richtung des Schneidstrahles vom Bedienungsmann beliebig ausrichten und bewegen, was durch die Kombination von drei, vorzugsweise senkrecht aufeinanderstehend über die Zwischenstücke 16 und 17 montierten erfindungsgemäßen Drehverbindungen I, II, III ermöglicht ist. Die Drehverbindungen selbst sind infolge der erfindungsgemäßen Anordnung der Führungs-,Schutz- und Stütz-Panzerung jeweils mit über Drehführungsflächen ineinander gleitend drehbar gelagertem hülsenartigem Fortsatz 14 und Hülse 15 gegen Verbiegung bei Manipulation und weiters auch gegen Korrosion bzw. Verschmutzung geschützt. Die Gefahr eines Bruches der erfindungsgemäßen Drehverbindung infolge von Fehlmanipulation ist praktisch ausgeschlossen.

Patentansprüche :

1. Drehdurchführung zur Führung von unter hohem Druck, insbesondere bis zu 5000 bar, vorzugsweise von 500 bis 4000 bar, stehenden flüssigen Medien durch im wesentlichen miteinander fluchtende Achsen aufweisende, gegeneinander verdrehbare Rohrteile (1,2) für Flüssigstrahl-Schneideinrichtungen, mit einen Führungskanal (110) für das Medium aufweisendem Gehäuseteil (1) und einem mit seinem Mediumsführungskanal (210) an den Gehäusekanal (110) im wesentlichen achsfluchtend anschließenden und am bzw. im Gehäuseteil (1) im wesentlichen um die Gehäuseachse drehbar gelagerten Drehkörper (2), dadurch gekennzeichnet, daß Gehäuseteil (1) und/oder Drehkörper (2) zusätzlich über mindestens eine, auf ihm bzw. ihnen angeordnete oder mit ihm bzw. ihnen in kraftschlüssiger Verbindung stehende , bevorzugt  nach außen weisende, vorzugsweise zylindermantelförmige, Führungsfläche (141, 142) und mindestens eine, entsprechend ausgebildete, der Führungsfläche (141, 142) zugekehrte, mit ihr kooperierende Führungsfläche (151, 152) mindestens einer im wesentlichen koaxial mit den genannten Teilen (1, 2) angeordneten Hülse  (15) in dieser Hülse (15) im wesentlichen um die gemeinsame Achse (A) drehbar gelagert ist, bzw. sind.

2. Drehdurchführung nach Anspruch 1, dadurch gekennzeichnet, daß die Hülse (15) mit Gehäuseteil (1) oder Drehkörper (2) über mindestens ein mit ihm,  vorzugsweise lösbar, verbundenes, Zwischenstück (16, 17) lösbar verbunden ist.

3. Drehdurchführung nach Anspruch 1 oder 2, dadurch gekennzeichnet, daß Drehkörper (2) oder Gehäuseteil (1) einen, gegebenenfalls über Verbindungs- (9, 10), Düsen-Anschluß- (19) und/oder Zwischenstück(e) (17), vorzugsweise lösbar, mit ihm verbundenen hülsenartigen Fortsatz (14) mit mindestens einer von der Achse (A) weg nach außen gerichteten, vorzugsweise zylindermantelförmigen ,Führungsfläche (141, 142) aufweist, die mit mindestens einer entsprechenden, ihr zugekehrten Führungsfläche (151, 152) einer den genannten Fortsatz (14) umgebenden, jeweils mit Gehäuseteil (1) oder Drehkörper (2), gegebenenfalls über Verbindungs-, Anschluß- (18) und/oder Zwischenstück(e) (16), vorzugsweise lösbar, verbundenen Hülse (15) kooperiert.

4. Drehdurchführung nach einem der Ansprüche 1 bis 3, dadurch gekennzeichnet, daß der hülsenartige Fortsatz (14) zumindest im Bereich seines freien Randes einen von der Achse (A) weg radial nach außen weisenden Vorsprung (143) mit zusammen mit einer Führungsfläche (151) der umgebenden Hülse (15) kooperierender Führungsfläche (141) und die Hülse (15) zumindest im Bereich ihres Randes einen radial nach innen zur Achse (A) hin gerichteten Vorsprung (153) mit zusammen mit einer Führungsfläche (142) am Außenmantel des hülsenartigen Fortsatzes (14) kooperierender Führungsfläche (152) aufweisen, und die Vorsprünge (143, 153), gegebenenfalls im Abstand voneinander, in Achsrichtung einander zugekehrte, vorzugsweise im wesentlichen normal zur Achse (A) sich erstreckende, ringartige Anschlagflächen (145, 155) aufweisen.

5. Drehdurchführung nach einem der Ansprüche 1 bis 4, dadurch gekennzeichnet, daß Hülse (15) und/oder hülsenartiger Fortsatz (14) jeweils mit einem mit Gehäuseteil (1) und/oder Drehstück (2), gegebenenfalls über zumindest ein Verbindungsstück, wie z.B. Druckschraube (9) mit Druckring (10), lösbar verbundenen, bevorzugt durch ein von einem, vorzugsweise 90-grädig abgewinkelten, Führungskanal (161, 171, 191, 181) durchsetztes, Winkelstück (16, 17), Düsenstück (19) und/oder Anschlußstück (18) gebildetes Zwischenstück, vorzugsweise lösbar, verbunden ist bzw. sind.

6. Drehdurchführung nach einem der Ansprüche 1 bis 5, dadurch gekennzeichnet, daß sie einen Gehäuseteil (1) mit vorzugsweise mit Anschlußelement, wie z.B. Verbindungsgewinde (11), ausgestattetem Gehäusebasisteil (100) mit Kanal (110), im Basisteil angeordneten Lagerteil (3) und lösbar mit ihm verbundenem Lagerhalte-Teil (6) mit Lager (7) und einen mit seiner Achse mit der Achse (A) des Gehäuseteiles (1) fluchtenden, vom Kanal (210) durchsetzten Drehkörper (2) mit, in einer entsprechenden Ausnehmung des Lagerteiles (3) drehbar gleitgelagertem Kanalfortsatz (21), am von Lagerhalte-Teil (6) des Gehäuseteiles (1) gehaltenen Lager (7) sich in axialer Richtung abstützendem, radialem Lagerhaltevorsprung (22) und einem Verbindungsstück, vorzugsweise Druckschraube (9) mit Druckring (10), aufweist.

7. Drehdurchführung nach einem der Ansprüche 1 bis 6, dadurch gekennzeichnet, daß der Kanalfortsatz (21) des Drehkörpers (2) gegen das Innere des Gehäusebasisteiles (100) mittels vom Lagerteil, insbesondere einer Druckschraube (3), gepreßter Dichtung mit, vorzugsweise zwischen Dichtungshaltern (5) angeordnetem, Dichtungsring (4) abgedichtet ist.

8. Drehdurchführung nach einem der Ansprüche 1 bis 7, dadurch gekennzeichnet, daß der Dichtungsring (4) im wesentlichen trapezförmigen Querschnitt mit zum von ihm abgedichteten Kanalfortsatz (21) des Drehstückes (2) hin gerichteter längerer Basisseite aufweist.

9. Drehdurchführung nach Anspruch 8, dadurch gekennzeichnet, daß die beiden Trapezflanken des Dichtungsringes (5) mit der Basisseite bzw. Ringinnenfläche einen Winkel zwischen 60 und 85 $^{\circ}$, insbesondere zwischen 75 und 85 $^{\circ}$, einschließen.

10. Drehdurchführung nach einem der Ansprüche 1 bis 9, dadurch gekennzeichnet, daß der Lagerteil (3) des Gehäuses (1) aus Buntmetall und der Drehkörper (2) mit in Lagerteil (3) gleitend gelagertem Kanalfortsatz (21) aus hochfestem Stahl gebildet sind.

11. Drehdurchführung nach einem der Ansprüche 1 bis 10, dadurch gekennzeichnet, daß Hülse (15) und hülsenartiger Fortsatz (14) jeweils aus verschiedenen Metallen, vorzugsweise aus Stahl und Buntmetall, gefertigt sind.

12. Drehdurchführung nach einem der Ansprüche 1 bis 11, dadurch gekennzeichnet, daß Gehäuseteil (1) und/oder Drehkörper (2) jeweils mit einem, vorzugsweise als Winkelstück (16, 17) ausgebildeten, Zwischenstück verbunden ist, bzw. sind, das seinerseits mit einem Gehäuseteil (1) und/oder Drehkörper (2) einer weiteren, vorzugsweise gleichartigen, Drehdurchführung (II) verbunden ist.

13. Drehdurchführung nach einem der Ansprüche 1 bis 12, dadurch gekennzeichnet, daß jedes, bevorzugt als Winkelstück (16, 17) ausgebildete, Zwischenstück jeweils mit zwei, vorzugsweise gleich ausgebildeten, Gehäuseteilen (1) oder zwei, vorzugsweise gleich ausgebildeten, Drehkörpern (2) verbindbar ist.

14. Drehdurchführung nach einem der Ansprüche 1 bis 13, dadurch gekennzeichnet, daß zur Ausbildung einer von flüssigen Medien mit hohem Druck durchströmbaren dreidimensional frei beweg- und ausrichtbaren Durchleitung für Hochdruck-Strahlschneideinrichtungen drei, vorzugsweise gleichartig ausgebildete, Drehdurchführungen (I, II, III) über zwei sie halternde, vorzugsweise 90-grädig abgewinkelte, Führungskanäle aufweisende Winkelstücke (16, 17) miteinander verbunden sind.

Fig. 2

Fig. 1

1/2

0125233

Fig. 3

2/2

0125233